# FASCICULE DE BREVET EUROPEEN

(11) **EP 3 364 468 B1**
(45) Date de publication et mention de la délivrance du brevet: **22.05.2019**
(21) Numéro de dépôt: 18156500.3
(22) Date de dépôt: 13.02.2018
(51) Int. Cl.: H01L 33/38, H01L 31/0224, H01L 29/861, H01L 29/417

(54) **DIODE À INJECTION ÉLECTRIQUE AMÉLIORÉE**
DIODE MIT VERBESSERTER ELEKTRISCHER INJEKTION
DIODE WITH IMPROVED ELECTRICAL INJECTION

(30) Priorité: 15.02.2017 FR 1751240
(43) Date de publication de la demande: 22.08.2018
(73) Titulaire: Commissariat à l'Energie Atomique et aux Energies Alternatives, 75015 Paris (FR)
(72) Inventeur: BONO, Hubert, 38000 GRENOBLE (FR); GARCIA, Jonathan, 38930 CLELLES-EN-TRIEVES (FR)
(74) Mandataire: Cabinet Beaumont

(56) Documents cités:
- EP-A2- 2 721 642
- WO-A1-2008/038842
- CN-A- 102 800 776
- US-A1- 2009 026 476
- US-A1- 2011 062 488
- US-A1- 2014 367 686

## Description

### Domaine

La présente demande concerne le domaine des diodes semiconductrices de façon générale. Selon un premier aspect, elle vise un dispositif comportant une pluralité de diodes. Selon un deuxième aspect, elle vise l'amélioration de l'injection du courant électrique d'alimentation dans une diode. Les exemples détaillés ci-après en relation avec les figures concernent essentiellement le domaine des diodes électroluminescentes au nitrure de gallium, domaine pour lequel les modes de réalisation décrits sont particulièrement avantageux. La présente demande ne se limite toutefois pas à ce domaine d'application particulier.

### Exposé de l'art antérieur

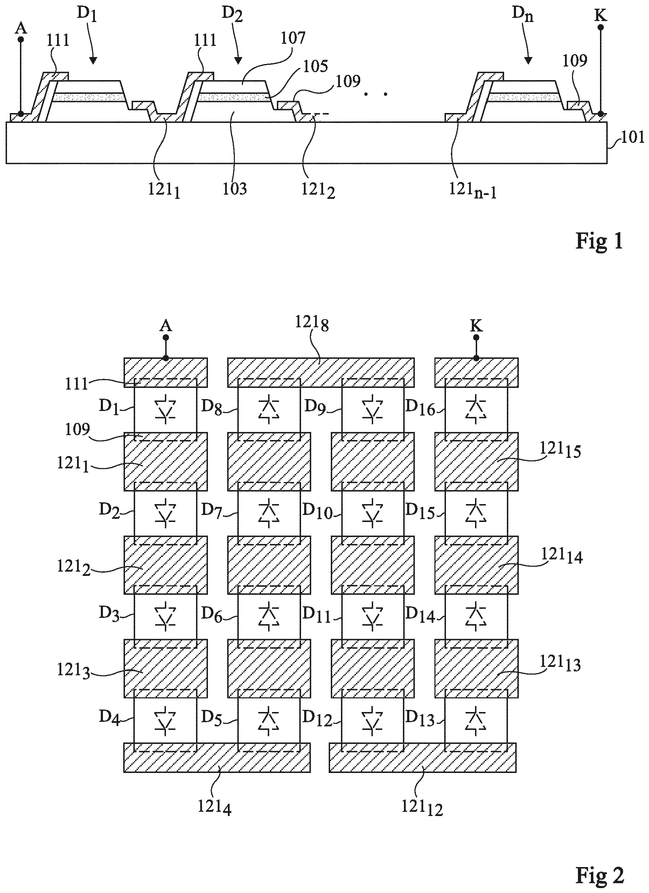

La figure 1 est une vue en coupe représentant de façon schématique un exemple d'un dispositif comportant une pluralité de diodes électroluminescentes au nitrure de gallium D₁, D₂, ..., Dₙ connectées en série, où n est un entier supérieur à 1. Une telle association série de diodes électroluminescentes est notamment adaptée à des applications d'éclairage, dans lesquelles la mise en série des diodes permet de pouvoir alimenter le dispositif sous une tension relativement élevée, tout en bénéficiant d'un rendement lumineux élevé.

Le dispositif de la figure 1 comprend un substrat de support en saphir 101, sur lequel sont disposées les diodes D₁, D₂, ..., Dₙ. Chaque diode Dᵢ (avec i entier allant de 1 à n) comprend une région active comportant un empilement vertical comprenant, dans l'ordre à partir de la surface supérieure du substrat 101, une couche de nitrure de gallium dopé de type N 103, une couche émissive 105, et une couche de nitrure de gallium dopé de type P 107. La couche 107 définit la région d'anode de la diode, et la couche 103 définit la région de cathode de la diode. La couche émissive 105 est par exemple constituée par un empilement vertical de plusieurs couches formant chacune un puits quantique.

La région active de chaque diode Dᵢ forme un plot ou ilot non adjacent à une région active d'une autre diode Dᵢ. Les diodes D₁, D₂, ..., Dₙ sont sensiblement identiques, aux dispersions de fabrication près. En particulier, les diodes D₁, D₂, ..., Dₙ, ont, en vue de dessus (non représentée), sensiblement la même forme générale, par exemple une forme carrée ou rectangulaire.

Chaque diode Dᵢ présente, du côté d'un bord latéral de sa région active, une région de prise de contact de cathode dans laquelle la couche d'anode 107 et la couche émissive 105 sont interrompues de façon à permettre la prise d'un contact électrique sur la face supérieure de la couche de cathode 103. Une métallisation de contact de cathode 109 est disposée sur et en contact avec la face supérieure de la couche de cathode 103 au niveau de la région de prise de contact de cathode.

Chaque diode Dᵢ comprend en outre une région de prise de contact d'anode située du côté d'un bord latéral de sa région active opposé à la région de prise de contact de cathode. Une métallisation de contact d'anode 111 est disposée sur et en contact avec la face supérieure de la couche d'anode 107 au niveau de la région de prise de contact d'anode.

Dans l'exemple de la figure 1, les diodes D₁, D₂, ..., Dₙ sont disposées en ligne par ordre d'indice ou rang i croissant, chaque diode Dᵢ, à l'exception de la diode Dₙ, ayant sa région de prise de contact de cathode tournée vers la région de prise de contact d'anode de la diode d'indice supérieur Dᵢ₊₁. Des métallisations d'interconnexion 121₁, 121₂, ..., 121ₙ₋₁ relient les diodes D₁, D₂, ..., Dₙ en série. Plus particulièrement, pour chaque diode Dᵢ à l'exception de la diode Dₙ, une métallisation d'interconnexion 121ᵢ est prévue, reliant la métallisation de contact de cathode 109 de la diode Dᵢ à la métallisation de contact d'anode 111 de la diode Dᵢ₊₁. La métallisation de contact d'anode 111 de la diode D₁ est reliée à une borne d'alimentation positive A ou borne de contact d'anode du dispositif, et la métallisation de contact de cathode 109 de la diode Dₙ est reliée à une borne d'alimentation négative K ou borne de contact de cathode du dispositif.

La figure 2 est une vue de dessus représentant de façon schématique une variante du dispositif de la figure 1. Dans l'exemple de la figure 2, le dispositif comprend n=16 diodes D₁, D₂, ..., D₁₆. Sur la figure 2, les diodes D₁, D₂, ..., D₁₆ ont été représentées de façon schématique par des carrés, ce qui correspond à la forme générale de leur région active en vue de dessus.

Le dispositif de la figure 2 diffère du dispositif de la figure 1 en ce que, dans le dispositif de la figure 2, les diodes D₁, D₂, ... Dₙ sont agencées non pas en ligne, mais en matrice, selon plusieurs lignes et plusieurs colonnes (4 lignes et 4 colonnes dans l'exemple représenté). Dans chaque colonne de la matrice, les diodes de la colonne sont connectées en série. Les diodes d'une même colonne sont orientées selon une même direction anode-cathode, les diodes de colonnes adjacentes étant orientées selon des directions anode-cathode opposées. Dans chaque colonne à l'exception des première et dernière colonnes de la matrice, les extrémités d'anode et de cathode de l'association en série des diodes de la colonne sont reliées respectivement à l'extrémité de cathode de l'association en série des diodes de la colonne précédente, et à l'extrémité d'anode de l'association en série des diodes de la colonne suivante, de façon que l'ensemble des n diodes D₁, D₂, ..., Dₙ soient reliées en série. L'extrémité d'anode de l'association en série des diodes de la première colonne est connectée à la borne A du dispositif, et l'extrémité de cathode de l'association en série des diodes de la dernière colonne est connectée à la borne K du dispositif.

Un inconvénient des dispositifs du type décrit en relation avec les figures 1 et 2 est que la longueur des régions de contact entre deux diodes consécutives de l'association série des diodes D₁, D₂, ..., Dₙ est limitée à la longueur d'un bord de la région active d'une diode. La résistance de connexion étant inversement proportionnelle à la longueur des régions de contact interconnectées, il en résulte que la résistance série globale du dispositif est relativement élevée.

De plus, un inconvénient des dispositifs à agencement matriciel du type décrit en relation avec la figure 2 est qu'il peut exister de fortes différences de potentiel entre deux diodes voisines de la matrice, notamment aux extrémités non interconnectées de colonnes adjacentes de la matrice. Par exemple, les diodes voisines D₁ et Dg, respectivement D₅ et D₁₂, respectivement D₉ et D₁₆ du dispositif de la figure 2 ont, en fonctionnement, leurs régions d'anodes et de cathodes polarisées à des potentiels relativement éloignés. Ceci impose des précautions particulières relativement contraignantes en termes d'isolation.

Par ailleurs, un problème qui se pose dans le domaine des diodes semiconductrices et en particulier dans le domaine des diodes électroluminescentes est celui de l'injection du courant électrique d'alimentation dans la région active de la diode. Ce problème se pose tout particulièrement dans le domaine des diodes au nitrure de gallium, du fait de la résistivité électrique relativement élevée du nitrure de gallium dopé de type N formant la région de cathode de la diode. On a déjà proposé, par exemple dans l'article intitulé "High performance GaN-based flip-chip LEDs with différent electrode patterns" de Ray-Hua Horng et al., des motifs de métallisation de cathode permettant de distribuer de façon relativement homogène le courant dans la région de cathode de la diode. Il serait toutefois souhaitable d'améliorer encore les performances d'injection du courant électrique dans une diode.

Document US 2011/062488 A1 se rapporte à une diode électroluminescente comprenant une électrode à géométrie améliorée. Document EP 2 721 642 A2 se rapporte à une cellule solaire comprenant une électrode à géométrie améliorée, Résumé.

Le mode de réalisation prévoit une diode comprenant un empilement vertical de première et deuxième régions semiconductrices de types de conductivité opposés, et une première électrode de polarisation de sa première région disposée dans une tranchée s'étendant depuis la face de la deuxième région opposée à la première région, la première électrode comprenant, en vue de dessus, les éléments conducteurs suivants :
un anneau polygonal ;
pour chaque sommet de l'anneau polygonal, un premier barreau rectiligne s'étendant entre le sommet et le centre de l'anneau, sensiblement selon une direction allant du sommet au centre de l'anneau ; et
pour chaque premier barreau, une pluralité de deuxièmes barreaux rectilignes s'étendant depuis le premier barreau sensiblement parallèlement aux côtés de l'anneau partant du sommet duquel est issu le premier barreau.

Selon le mode de réalisation, les dimensions des premiers et deuxièmes barreaux sont telles que le volume de la deuxième région situé, vu de dessus, à l'intérieur de l'anneau, est continu.

Selon un mode de réalisation, pour chaque premier barreau, la première électrode comprend une ou plusieurs paires de deuxièmes barreaux issus du premier barreau, et, dans chaque paire de deuxièmes barreaux, les barreaux de la paire partent d'un même point du premier barreau.

Selon un mode de réalisation, dans chaque paire de deuxièmes barreaux :
un premier barreau de la paire s'étend sensiblement parallèlement à un premier côté de l'anneau relié au sommet duquel est issu le premier barreau duquel sont issus les deuxièmes barreaux de la paire, en direction opposée à un deuxième côté de l'anneau relié audit sommet ; et
un deuxième barreau de la paire s'étend sensiblement parallèlement au deuxième côté de l'anneau relié au sommet duquel est issu le premier barreau duquel sont issus les barreaux de la paire, en direction opposée au premier côté de l'anneau relié audit sommet.

Selon un mode de réalisation, pour chaque premier barreau, les paires de deuxièmes barreaux reliées au premier barreau sont régulièrement réparties le long du premier barreau.

Selon un mode de réalisation, chaque deuxième barreau s'interrompt avant d'atteindre une droite reliant le centre de l'anneau au milieu du côté de l'anneau parallèle au deuxième barreau et relié au sommet duquel est issu le premier barreau duquel est issu le deuxième barreau.

Selon un mode de réalisation, la diode comporte en outre une deuxième électrode de polarisation de sa deuxième région disposée sur la face de la deuxième région opposée à la première région.

Selon un mode de réalisation, la deuxième électrode a, vue de dessus, la forme d'un anneau inclus dans l'anneau polygonal de la première électrode.

Selon un mode de réalisation, l'anneau de la deuxième électrode est interrompu au niveau de chacune des intersections avec les premiers barreaux de la première électrode de façon à ne pas passer au-dessus desdits premiers barreaux.

Selon un mode de réalisation, l'anneau de la deuxième électrode est continu, et les premiers barreaux de la première électrode sont interrompus aux intersections avec l'anneau de la deuxième électrode de façon à ne pas passer sous ledit anneau.

Selon un mode de réalisation, l'anneau polygonal de la première électrode est séparé en deux parties disjointes s'étendant chacune sur sensiblement la moitié de la longueur de la périphérie de la diode.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, précédemment décrite, est une vue en coupe représentant de façon schématique un exemple d'un dispositif comportant une pluralité de diodes reliées en série ;
la figure 2, précédemment décrite, est une vue en coupe représentant de façon schématique un autre exemple d'un dispositif comportant une pluralité de diodes reliées en série ;
les figures 3A et 3B sont respectivement une vue de dessus et une vue en coupe représentant de façon schématique un exemple d'un dispositif comportant une pluralité de diodes selon un mode de réalisation, qui ne fait pas partie de l'invention telle que revendiquée ;
la figure 4 est un schéma électrique d'un exemple d'un dispositif comportant une pluralité de diodes interconnectées selon un mode de réalisation, qui ne fait pas partie de l'invention telle que revendiquée ;
les figures 5A et 5B sont respectivement une vue de dessus et une vue en coupe illustrant un exemple d'un mode de réalisation du dispositif de la figure 4, qui ne fait pas partie de l'invention telle que revendiquée ;
la figure 6 est un schéma électrique d'un autre exemple de dispositif comportant une pluralité de diodes interconnectées selon un mode de réalisation, qui ne fait pas partie de l'invention telle que revendiquée ;
les figures 7A et 7B sont respectivement une vue de dessus et une vue en coupe illustrant un exemple d'un mode de réalisation du dispositif de la figure 6, qui ne fait pas partie de l'invention telle que revendiquée ;
les figures 8A et 8B sont respectivement une vue de dessus et une vue en coupe illustrant de façon schématique un exemple d'un mode de réalisation d'une diode semiconductrice ;
la figure 9 est une vue de dessus illustrant de façon schématique une variante de réalisation de la diode des figures 8A et 8B ;
la figure 10 est une vue de dessus illustrant de façon schématique une autre variante de réalisation de la diode des figures 8A et 8B ; et
les figures 11A, 11B, 11C, 11D, 11E, 11F sont des vues en coupe illustrant de façon schématique et partielle un exemple d'un mode de réalisation d'un procédé de fabrication d'un dispositif comportant une ou plusieurs diodes semiconductrices.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les circuits de commande qui peuvent être utilisés pour commander les dispositifs décrits n'ont pas été détaillés, les modes de réalisation décrits étant compatibles avec les circuits de commande usuels de diodes semiconductrices. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des vues en coupe des figures, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près, ou, lorsqu'elles se rapportent à des valeurs angulaires ou à des orientations, à 10 degrés près, de préférence à 5 degrés près.

### Premier aspect, qui ne fait pas partie de l'invention telle que revendiquée (dispositif comportant une pluralité de diodes)

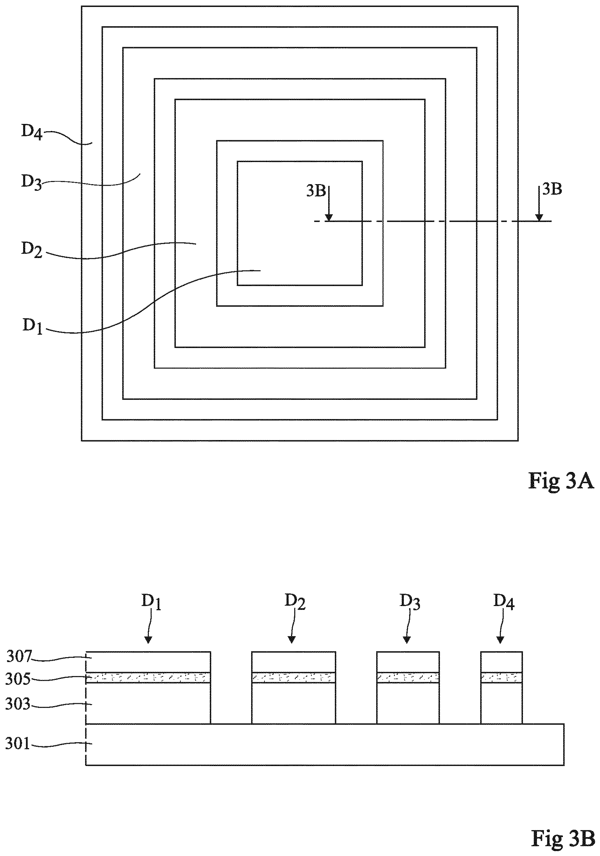

Les figures 3A et 3B représentent de façon schématique un exemple d'un mode de réalisation, qui ne fait pas partie de l'invention telle que revendiquée, d'un dispositif comportant une pluralité de diodes électroluminescentes au nitrure de gallium. La figure 3A est une vue de dessus du dispositif, et la figure 3B est une vue en coupe partielle du dispositif selon le plan 3B-3B de la figure 3A.

Le dispositif des figures 3A et 3B comprend quatre diodes électroluminescentes au nitrure de gallium D₁, D₂, D₃, D₄. Plus généralement, les modes de réalisation décrits en relation avec les figures 3A, 3B, 4, 5A, 5B, 6, 7A et 7B s'appliquent quel que soit le nombre n de diodes D₁, D₂, ..., Dₙ du dispositif, avec n entier supérieur à 1.

Le dispositif des figures 3A et 3B comprend un substrat de support 301 (figure 3B) sur la face supérieure duquel sont disposées les diodes D₁, D₂, ..., Dₙ. Le substrat 301 est par exemple en saphir ou en tout autre matériau adapté. Le substrat 301 est par exemple transparent.

Chaque diode Dᵢ, avec i entier allant de 1 à n, comprend une région active comportant un empilement vertical comprenant, dans l'ordre à partir de la surface supérieure du substrat 301, une couche de nitrure de gallium dopé de type N 303, une couche émissive 305, et une couche de nitrure de gallium dopé de type P 307. La couche 307 définit la région d'anode de la diode, et la couche 303 définit la région de cathode de la diode. La couche émissive 305 est par exemple constituée par un empilement vertical d'une ou plusieurs couches formant chacune un puit quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, la couche émissive 305 peut être une couche de nitrure de gallium intrinsèque, c'est-à-dire non intentionnellement dopée. Dans cet exemple, la face inférieure de la couche émissive 305 est en contact avec la face supérieure de la couche de cathode 303, et la face supérieure de la couche émissive 305 est en contact avec la face inférieure de la couche d'anode 307. En pratique, selon la nature du substrat 301, un empilement d'une ou plusieurs couches tampon (non représentées) peut faire interface entre le substrat de support 301 et la couche de nitrure de gallium 303.

La région active de chaque diode Dᵢ est non adjacente à une région active d'une autre diode Dᵢ du dispositif. Autrement dit, les régions actives des différentes diodes Dᵢ sont séparées les unes des autres par des tranchées traversant entièrement l'empilement formé par les couches actives 303, 305 et 307 du dispositif, ce qui permet notamment de pouvoir interconnecter en série des diodes du dispositif. Les couches actives 303, 305 et 307 de chaque diode Dᵢ sont en revanche des couches continues.

Par souci de clarté, les métallisations de contact d'anode et de cathode des diodes, et les éventuels éléments d'isolation et d'interconnexion des diodes n'ont pas été représentés sur les figures 3A et 3B.

Selon un aspect d'un mode de réalisation, les diodes D₁, D₂, ..., Dₙ du dispositif des figures 3A et 3B sont coplanaires et concentriques.

On entend ici par coplanaires que les diodes D₁, D₂, ..., Dₙ ne sont pas superposées les unes aux autres, mais sont disposées sensiblement dans un même plan moyen parallèle à la face supérieure du substrat de support 301. Autrement dit, la distance entre le substrat de support 301 et la jonction PN ou la couche émissive de chaque diode Dᵢ, est sensiblement la même pour toutes les diodes D₁, D₂, ..., Dₙ du dispositif.

Par ailleurs, on entend ici par concentriques que, à l'exception d'une diode Dᵢ que l'on appellera diode centrale (la diode D₁ dans l'exemple des figures 3A et 3B), dont la région active peut avoir une forme quelconque, les régions actives des autres diodes Dᵢ ont, vu de dessus, la forme d'anneaux imbriqués entourant la région active de la diode centrale. A titre d'exemple, les régions actives des diodes D₁, D₂, ..., Dₙ ont, vu de dessus, un même centre de symétrie. Dans l'exemple représenté, en vue de dessus, les dimensions extérieures des diodes D₁, D₂, ... Dₙ sont croissantes en fonction de l'indice ou rang i de la diode. Autrement dit, à l'exception de la diode centrale D₁, chaque diode Dᵢ entoure entièrement la diode d'indice immédiatement inférieur Dᵢ₋₁. De plus, à l'exception de la diode Dₙ, chaque diode Dᵢ est entièrement entourée par la diode d'indice immédiatement supérieur Dᵢ₊₁. Dans l'exemple représenté, vu de dessus, la région active de la diode centrale D₁ a une forme générale carrée, et la région active de chaque autre diode Dᵢ a une forme en anneau carré ayant sensiblement le même centre que la région active de la diode D₁. A titre de variante, les diodes D₁, D₂, ... Dₙ peuvent avoir, en vue de dessus, des formes rectangulaires, circulaires, elliptiques, ou toutes autres formes non nécessairement symétriques, par exemple des formes triangulaires.

De préférence, les diodes D₁, D₂, ..., Dₙ sont dimensionnées de façon à avoir toutes sensiblement la même surface de région active.

A titre d'exemple, les distances séparant deux à deux des diodes consécutives du dispositif sont toutes sensiblement identiques.

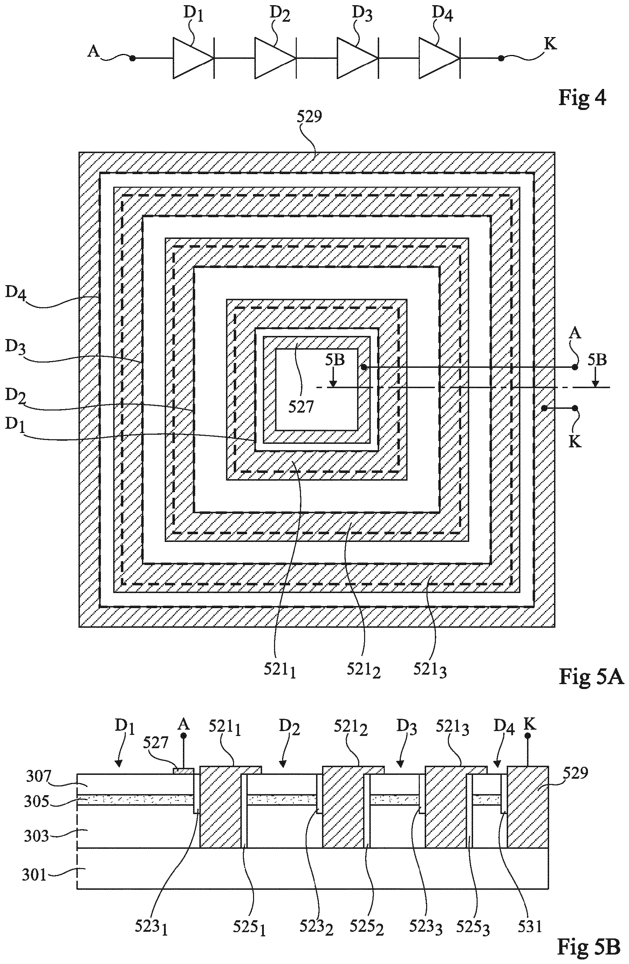

La figure 4 est un schéma électrique d'un exemple d'un dispositif comportant n diodes D₁, D₂, ... Dₙ interconnectées (n=4 dans l'exemple représenté).

Dans l'exemple de la figure 4, les diodes D₁, D₂, ..., Dₙ sont connectées en série entre une borne d'alimentation positive A ou borne de contact d'anode du dispositif, et une borne d'alimentation négative K ou borne de contact de cathode du dispositif. Plus particulièrement, chaque diode Dᵢ à l'exception de la diode Dₙ a sa cathode connectée à l'anode de la diode d'indice immédiatement supérieur Dᵢ₊₁, l'anode de la diode D₁ étant connectée à la borne A et la cathode de la diode Dₙ étant connectée à la borne K.

Les figures 5A et 5B illustrent un exemple de connexion des diodes concentriques D₁, D₂, ..., Dₙ du dispositif des figures 3A et 3B selon le schéma électrique de la figure 4. Les figures 5A et 5B sont des vues selon les mêmes orientations que les figures 3A et 3B respectivement. Plus particulièrement, la figure 5A est une vue de dessus du dispositif, et la figure 5B est une vue en coupe partielle du dispositif selon le plan 5B-5B de la figure 5A. Les éléments communs entre les figures 3A, 3B et les figures 5A, 5B ne seront pas détaillés à nouveau. Pour plus de lisibilité, sur la vue de dessus de la figure 5A, les régions actives des diodes D₁, D₂, ..., Dₙ ont été représentées de façon schématique par des traits interrompus délimitant leurs contours.

Le dispositif des figures 5A et 5B comprend des métallisations d'interconnexion 521₁, 521₂, ..., 521ₙ₋₁ reliant les diodes D₁, D₂, ..., Dₙ en série. Plus particulièrement, pour chaque diode Dᵢ à l'exception de la diode Dₙ, une métallisation d'interconnexion 521ᵢ est prévue, reliant la région de cathode 303 de la diode Dᵢ à la région d'anode 307 de la diode Dᵢ₊₁. Chaque métallisation 521ᵢ revêt les parois latérales et le fond de la tranchée périphérique ou tranchée annulaire séparant la diode Dᵢ de la diode Dᵢ₊₁. Dans l'exemple représenté, chaque métallisation 521ᵢ remplit entièrement la tranchée périphérique séparant la diode Dᵢ de la diode Dᵢ₊₁. La métallisation 521ᵢ est en contact avec le flanc extérieur de la région de cathode 303 de la diode Dᵢ sur sensiblement toute la longueur de la tranchée périphérique séparant la diode Dᵢ de la diode Dᵢ₊₁. Les flancs extérieurs des couches 305 et 307 de la diode Dᵢ sont quant à eux revêtus d'une couche isolante 523ᵢ, isolant notamment la région d'anode 307 de la diode Dᵢ de la métallisation 521ᵢ. De plus, les flancs intérieurs des couches 303, 305 et 307 de la diode Dᵢ₊₁ sont revêtus d'une couche isolante 525ᵢ, isolant notamment la région de cathode 303 de la diode Dᵢ₊₁ de la métallisation 521ᵢ. Par souci de simplification, les régions isolantes 523ᵢ et 525ᵢ n'ont pas été détaillées sur la figure 5A. Chaque métallisation 521ᵢ se prolonge en outre au-dessus d'une bande périphérique de la région d'anode 307 de la diode Dᵢ₊₁ située du côté du bord intérieur de la diode Dᵢ₊₁. Ce prolongement de la métallisation 521ᵢ est en contact avec la face supérieure de la région d'anode 307 de la diode Dᵢ₊₁ sur sensiblement toute la longueur de la tranchée périphérique séparant les diodes Dᵢ et Dᵢ₊₁. Ainsi, chaque métallisation 521ᵢ connecte sensiblement toute la périphérie extérieure de la région de cathode de la diode Dᵢ à sensiblement toute la périphérie intérieure de la région d'anode de la diode Dᵢ₊₁.

Le dispositif des figures 5A et 5B comprend en outre une métallisation de contact d'anode 527 disposée en contact avec la région d'anode 307 de la diode D₁. Dans cet exemple, la métallisation 527 est disposée sur et en contact avec la face supérieure de la région d'anode 307 de la diode D₁. Plus particulièrement, dans l'exemple représenté, la métallisation 527 présente, en vue de dessus, une forme annulaire s'étendant au-dessus d'une bande périphérique de la région d'anode 307 de la diode D₁.

Le dispositif des figures 5A et 5B comprend en outre une métallisation de contact de cathode 529 disposée en contact avec la région de cathode 303 de la diode Dₙ. Dans cet exemple, la métallisation 529 est disposée sur et en contact avec le flanc extérieur de la région de cathode 303 de la diode Dₙ. Plus particulièrement, dans l'exemple représenté, la métallisation 529 est en contact avec le flanc extérieur de la diode Dₙ sur sensiblement toute la longueur de la périphérie extérieure de la diode Dₙ. Les flancs extérieurs des couches 305 et 307 de la diode Dₙ sont quant à eux revêtus d'une couche isolante 531, isolant notamment la région d'anode 307 de la diode Dₙ de la métallisation 529.

La métallisation de contact d'anode 527 de la diode D₁ est connectée à la borne positive A du dispositif, et la métallisation de contact de cathode 529 de la diode Dₙ est connectée à la borne négative K du dispositif.

Par rapport aux dispositifs des figures 1 et 2, un avantage du dispositif décrit en relation avec les figures 5A et 5B est que la longueur des régions de contact entre deux diodes consécutives Dᵢ et Dᵢ₊₁ de l'association série des diodes D₁, D₂, ..., Dₙ s'étend sur sensiblement toute la longueur du contour extérieur de la diode Dᵢ. Ceci permet de réduire significativement la résistance série globale du dispositif.

De plus, par rapport au dispositif de la figure 2, un avantage du dispositif décrit en relation avec les figures 5A et 5B est que la différence de potentiel maximale entre deux diodes adjacentes du dispositif est limitée à la chute de tension d'une diode, ce qui permet de relâcher les contraintes d'isolation des diodes.

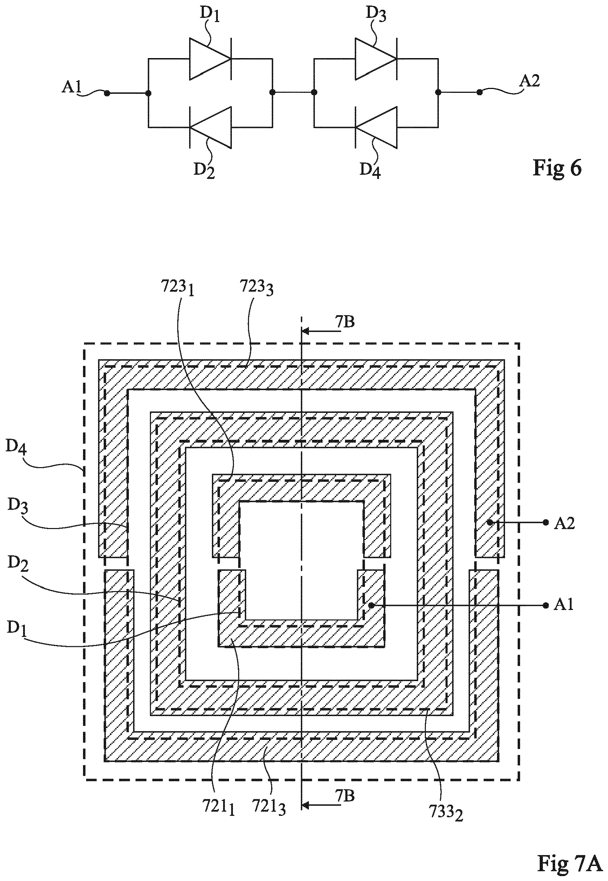

La figure 6 est un schéma électrique d'un autre exemple d'un dispositif comportant n diodes D₁, D₂, ... Dₙ interconnectées, où n est un nombre pair (n=4 dans l'exemple représenté).

Dans l'exemple de la figure 6, les diodes D₁, D₂, ..., Dₙ sont connectées deux à deux en antiparallèle, les associations de deux diodes en antiparallèle étant connectées en série entre des bornes d'alimentation A1 et A2 du dispositif. Dans l'exemple représenté, chaque diode d'indice impair Dᵢ est connectée en antiparallèle de la diode Dᵢ₊₁ d'indice pair immédiatement supérieur, c'est-à-dire que son anode est connectée à la cathode de la diode Dᵢ₊₁ et que sa cathode est connectée à l'anode de la diode Dᵢ₊₁. Les associations de deux diodes en antiparallèle sont reliées en série entre les bornes A1 et A2 du dispositif. Plus particulièrement, chaque association de deux diodes Dᵢ et Dᵢ₊₁ en antiparallèle (où i est l'indice de rang impair de l'association), à l'exception de l'association des diodes Dₙ₋₁ et Dₙ, a son noeud commun entre la cathode de la diode Dᵢ et l'anode de la diode Dᵢ₊₁ connecté au noeud commun entre l'anode de la diode Dᵢ₊₂ et la cathode de la diode Dᵢ₊₃ de l'association suivante. Le noeud commun entre l'anode de la diode D₁ et la cathode de la diode D₂ est connecté à la borne A1 du dispositif, et le noeud commun entre la cathode de la diode Dₙ₋₁ et l'anode de la diode Dₙ est connecté à la borne A2 du dispositif.

Une telle association série/antiparallèle de diodes est notamment adaptée à des applications d'éclairage, dans lesquelles ce schéma d'interconnexion des diodes permet d'alimenter le dispositif au moyen d'une tension alternative appliquée entre les bornes A1 et A2. Pendant les alternances positives de la tension appliquée entre les bornes A1 et A2, seules les diodes de rang impair sont passantes et émettent de la lumière, tandis que les diodes de rang pair sont bloquées et éteintes. Pendant les alternances négatives, les diodes de rang pair prennent le relais et émettent de la lumière, tandis que les diodes de rang impair sont bloquées et éteintes.

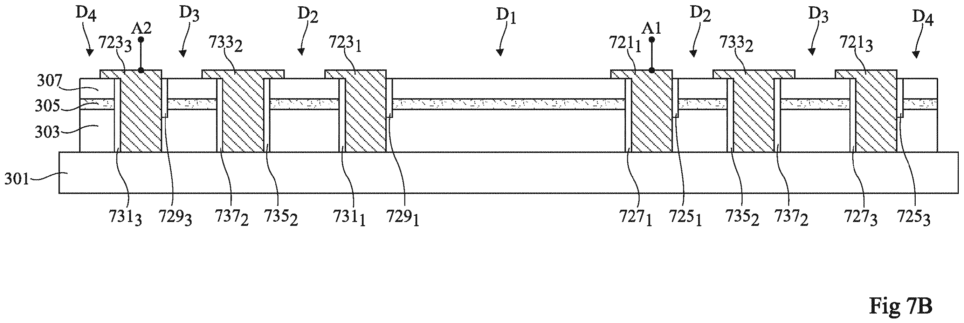

Les figures 7A et 7B illustrent un exemple de connexion des diodes concentriques D₁, D₂, ..., Dₙ du dispositif des figures 3A et 3B selon le schéma électrique de la figure 6. La figure 7A est une vue de dessus du dispositif, et la figure 7B est une vue en coupe du dispositif selon le plan 7B-7B de la figure 7A. Les éléments communs entre les figures 3A, 3B et les figures 7A, 7B ne seront pas détaillés à nouveau. Sur la vue de dessus de la figure 7A, les régions actives des diodes D₁, D₂, ..., Dₙ ont été représentées de façon schématique par des traits interrompus délimitant leurs contours.

Le dispositif des figures 7A et 7B comprend, pour chaque diode Dᵢ de rang impair, une première métallisation d'interconnexion 721ᵢ reliant la région d'anode 307 de la diode Dᵢ à la région de cathode 303 de la diode Dᵢ₊₁, et une deuxième métallisation d'interconnexion 723ᵢ isolée de la première métallisation 721ᵢ, reliant la région de cathode 303 de la diode Dᵢ à la région d'anode 307 de la diode Dᵢ₊₁.

Vu de dessus, chaque métallisation 721ᵢ s'étend de façon continue le long d'une première moitié de la tranchée périphérique séparant les diodes Dᵢ et Dᵢ₊₁, et chaque métallisation 723ᵢ s'étendant de façon continue le long de la deuxième moitié de la tranchée périphérique séparant les diodes Dᵢ et Dᵢ₊₁.

Chaque métallisation 721ᵢ revêt les parois latérales et le fond de la première moitié de la tranchée périphérique séparant les diodes Dᵢ et Dᵢ₊₁, et se prolonge au-dessus d'une bande périphérique de la région d'anode 307 de la diode Dᵢ située du côté du bord extérieur de la diode Dᵢ, le long de ladite première moitié de la tranchée périphérique séparant les diodes Dᵢ et Dᵢ₊₁. Dans l'exemple représenté, la métallisation 721ᵢ remplit entièrement la première moitié de la tranchée périphérique séparant la diode Dᵢ de la diode Dᵢ₊₁. La métallisation 721ᵢ est en contact avec le flanc intérieur de la région de cathode 303 de la diode Dᵢ₊₁ sur sensiblement toute la longueur de la première moitié de tranchée périphérique séparant les diodes Dᵢ et Dᵢ₊₁. Les flancs intérieurs des couches 305 et 307 de la diode Dᵢ₊₁ sont quant à eux revêtus d'une couche isolante 725ᵢ, isolant notamment la région d'anode 307 de la diode Dᵢ₊₁ de la métallisation 721i sur sensiblement toute la longueur de la première moitié de la tranchée périphérique séparant les diodes Dᵢ et Dᵢ₊₁. De plus, les flancs extérieurs des couches 303, 305 et 307 de la diode Dᵢ sont revêtus d'une couche isolante 727ᵢ, isolant la région de cathode 303 de la diode Dᵢ de la métallisation 721ᵢ. La métallisation 721ᵢ est en outre en contact avec la face supérieure de la région d'anode 307 de la diode Dᵢ sur sensiblement toute la longueur de la première moitié de la tranchée périphérique séparant les diodes Dᵢ et Dᵢ₊₁. Ainsi, chaque métallisation 721ᵢ connecte sensiblement toute la première moitié de la périphérie extérieure de la région d'anode de la diode Dᵢ à sensiblement toute la première moitié de la périphérie intérieure de la région de cathode de la diode Dᵢ₊₁.

Chaque métallisation 723ᵢ revêt les parois latérales et le fond de la deuxième moitié de la tranchée périphérique séparant les diodes Dᵢ et Dᵢ₊₁, et se prolongeant au-dessus d'une bande périphérique de la région d'anode 307 de la diode Dᵢ₊₁ située du côté du bord intérieur de la diode Dᵢ₊₁, le long de ladite deuxième moitié de la tranchée périphérique séparant les diodes Dᵢ et Dᵢ₊₁. Dans l'exemple représenté, la métallisation 723ᵢ remplit entièrement la deuxième moitié de la tranchée périphérique séparant la diode Dᵢ de la diode Dᵢ₊₁. La métallisation 723ᵢ est en contact avec le flanc extérieur de la région de cathode 303 de la diode Dᵢ sur sensiblement toute la longueur de la deuxième moitié de la tranchée périphérique séparant les diodes Dᵢ et Dᵢ₊₁. Les flancs extérieurs des couches 305 et 307 de la diode Dᵢ sont quant à eux revêtus d'une couche isolante 729ᵢ, isolant notamment la région d'anode 307 de la diode Dᵢ de la métallisation 723ᵢ sur sensiblement toute la longueur de la deuxième moitié de la tranchée périphérique séparant les diodes Dᵢ et Dᵢ₊₁. De plus, les flancs intérieurs des couches 303, 305 et 307 de la diode Dᵢ₊₁ sont revêtus d'une couche isolante 731ᵢ, isolant notamment la région de cathode 303 de la diode Dᵢ₊₁ de la métallisation 723ᵢ, sur sensiblement toute la longueur de la deuxième moitié de la tranchée périphérique séparant les diodes Dᵢ et Dᵢ₊₁. La métallisation 723ᵢ est en outre en contact avec la face supérieure de la région d'anode 307 de la diode Dᵢ₊₁ sur sensiblement toute la longueur de la deuxième moitié de la tranchée périphérique séparant les diodes Dᵢ et Dᵢ₊₁. Ainsi, chaque métallisation 723ᵢ connecte sensiblement toute la deuxième moitié de la périphérie extérieure de la région de cathode de la diode Dᵢ à sensiblement toute la deuxième moitié de la périphérie intérieure de la région d'anode de la diode Dᵢ₊₁.

Le dispositif des figures 7A et 7B comprend, pour chaque diode Dᵢ de rang pair à l'exception de la diode Dₙ, une métallisation d'interconnexion 733ᵢ reliant la région d'anode 307 de la diode Dᵢ à la région d'anode 307 de la diode Dᵢ₊₁.

Vu de dessus, chaque métallisation 733ᵢ s'étend de façon continue sur sensiblement toute la longueur de la tranchée périphérique séparant les diodes Dᵢ et Dᵢ₊₁.

Chaque métallisation 733ᵢ revêt les parois latérales et le fond de la tranchée périphérique séparant les diodes Dᵢ et D₁₊₁. Dans l'exemple représenté, chaque métallisation 733ᵢ remplit entièrement la tranchée périphérique séparant la diode Dᵢ de la diode Dᵢ₊₁. Les flancs extérieurs des couches 303, 305 et 307 de la diode Dᵢ sont revêtus d'une couche isolante 735ᵢ, isolant notamment la région de cathode 303 de la diode Dᵢ de la métallisation 733ᵢ sur toute la longueur de la tranchée périphérique séparant les diodes Dᵢ et Dᵢ₊₁. De plus, les flancs intérieurs des couches 303, 305 et 307 de la diode Dᵢ₊₁ sont revêtus d'une couche isolante 737ᵢ, isolant notamment la région de cathode 303 de la diode Dᵢ₊₁ de la métallisation 733ᵢ sur toute la longueur de la tranchée périphérique séparant les diodes Dᵢ et Dᵢ₊₁. Chaque métallisation 733ᵢ se prolonge en outre, sur toute la longueur de la tranchée périphérique séparant les diodes Dᵢ et Dᵢ₊₁, au-dessus d'une bande périphérique de la région d'anode 307 de la diode annulaire Dᵢ₊₁ située du côté du bord intérieur de la diode Dᵢ₊₁. Ce prolongement de la métallisation 733ᵢ est en contact avec la face supérieure de la région d'anode 307 de la diode Dᵢ₊₁ sur toute la longueur de la tranchée périphérique séparant les diodes Dᵢ et Dᵢ₊₁. Chaque métallisation 733ᵢ se prolonge en outre, sur toute la longueur de la tranchée périphérique séparant les diodes Dᵢ et Dᵢ₊₁, au-dessus d'une bande périphérique de la région d'anode 307 de la diode annulaire Dᵢ située du côté du bord extérieur de la diode Dᵢ. Ce prolongement de la métallisation 733ᵢ est en contact avec la face supérieure de la région d'anode 307 de la diode Dᵢ sur sensiblement toute la longueur de la tranchée périphérique séparant les diodes Dᵢ et Dᵢ₊₁. Ainsi, chaque métallisation 733ᵢ connecte sensiblement toute la périphérie extérieure de la région d'anode de la diode Dᵢ à sensiblement toute la périphérie intérieure de la région d'anode de la diode Dᵢ₊₁.

La métallisation 721₁ reliant l'anode de la diode D₁ à la cathode de la diode D₂ est connectée à la borne A1 du dispositif, et la métallisation 723ₙ₋₁ reliant la cathode de la diode Dₙ₋₁ à l'anode de la diode Dₙ est connectée à la borne A2 du dispositif.

Le dispositif des figures 7A et 7B présente sensiblement les mêmes avantages que le dispositif des figures 5A et 5B en terme de résistance série globale du dispositif et en terme de différence de potentiel maximale entre deux diodes voisines du dispositif.

### Deuxième aspect (diode à injection électrique améliorée)

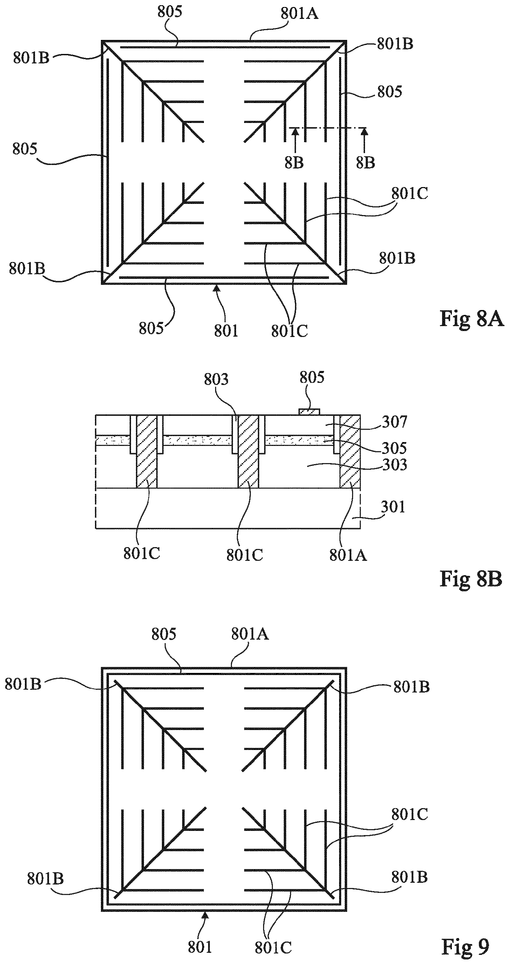

Les figures 8A et 8B illustrent de façon schématique un exemple d'un mode de réalisation d'une diode semiconductrice. La figure 8A est une vue de dessus de la diode, et la figure 8B est une vue en coupe partielle selon le plan 8B-8B de la figure 8A.

Comme dans les exemples précédents, la diode des figures 8A et 8B est une diode électroluminescente au nitrure de gallium disposée sur un substrat de support 301, par exemple en saphir, et dont la région active comprend un empilement vertical comportant, dans l'ordre à partir de la face supérieure du substrat 301, une couche de nitrure de gallium dopé de type N 303, définissant la région de cathode de la diode, une couche émissive 305, et une couche de nitrure de gallium dopé de type P 307, définissant la région de cathode de la diode.

La diode des figures 8A et 8B comprend une électrode 801 de polarisation de sa région de cathode 303, disposée dans une tranchée s'étendant depuis la face supérieure de la couche d'anode 307 et traversant entièrement la couche d'anode 307. L'électrode 801 est en contact avec les flancs de la couche de cathode 303 à l'intérieur de la tranchée. Les flancs des couches 305 et 307 sont quant à eux revêtus d'une couche isolante 803, permettant notamment d'isoler la région d'anode 307 de la diode de l'électrode 801. Dans l'exemple représenté, l'électrode 801 remplit entièrement la tranchée dans laquelle elle est disposée.

En vue de dessus, le motif conducteur de l'électrode de cathode 801 comprend les éléments suivants :
un anneau polygonal 801A ;
pour chaque sommet de l'anneau polygonal 801A, un barreau rectiligne 801B s'étendant depuis le sommet de l'anneau sensiblement en direction du centre de l'anneau, le barreau 801B s'interrompant avant le centre de l'anneau ; et
pour chaque barreau 801B, une pluralité de barreaux rectilignes 801C s'étendant depuis le barreau 801B sensiblement parallèlement aux côtés de l'anneau reliés au sommet duquel est issu le barreau 801B.

Par centre de l'anneau polygonal, on entend ici le barycentre de l'anneau, qui peut être un centre de symétrie dans le cas d'un anneau symétrique, par exemple dans le cas d'un polygone régulier.

A titre d'exemple, l'anneau polygonal 801A entoure, vu de dessus, la région active de la diode.

Pour chaque barreau 801B, l'électrode 801 comprend une ou plusieurs paires de barreaux 801C, par exemple régulièrement réparties entre les deux extrémités du barreau 801B. Dans chaque paire de barreaux 801C, les premier et deuxième barreaux 801C de la paire partent d'un même point du barreau 801B, et s'étendent respectivement de part et d'autre du barreau 801B. Plus particulièrement, le premier barreau 801C de la paire s'étend parallèlement à un premier côté de l'anneau relié au sommet duquel est issu le barreau 801B, en direction opposée au deuxième côté de l'anneau relié audit sommet, et le deuxième barreau 801C de la paire s'étend parallèlement au deuxième côté de l'anneau relié audit sommet, en direction opposée au premier côté de l'anneau relié audit sommet.

L'agencement et le dimensionnement des barreaux 801B et 801C est choisi de façon que le volume de la région d'anode 307 de la diode situé, en vue de dessus, à l'intérieur de l'anneau 801A soit continu. En particulier, dans l'exemple représenté, chaque barreau 801C s'interrompt avant d'atteindre la droite reliant le centre de l'anneau au milieu du côté de l'anneau parallèle au barreau 801C et relié au sommet duquel est issu le barreau 801B duquel est issu le barreau 801C.

La continuité de la région d'anode 307 permet de pouvoir polariser cette dernière à l'aide d'une électrode unique, située par exemple au voisinage de la périphérie de la diode.

Dans l'exemple représenté, la diode comprend une électrode 805 de polarisation de sa région d'anode 307, disposée sur et en contact avec la face supérieure de la région d'anode 307. Dans cet exemple, l'électrode 805 a, vue de dessus, la forme d'un anneau polygonal sensiblement de même forme que l'anneau 801A, mais de dimensions inférieures, inclus dans l'anneau 801A. Dans cet exemple, l'anneau 805 est ouvert au niveau de chacun de ses sommets de façon à ne pas passer au-dessus des barreaux 801B de l'électrode de cathode 801.

La figure 9 illustre une variante de réalisation dans laquelle l'anneau 805 de l'électrode d'anode est continu, et dans laquelle les barreaux 801B de l'électrode de cathode 801 s'interrompent aux intersections avec l'anneau 805 de façon à ne pas passer sous l'anneau 805.

L'agencement d'électrode de cathode décrit dans l'exemple des figures 8A et 8B et dans la variante de la figure 9 présente l'avantage de permettre une bonne distribution du courant dans la région de cathode de la diode. Cet agencement d'électrode améliore ainsi l'injection électrique dans la diode, ce qui permet d'accroitre le rendement lumineux de la diode par rapport aux agencements d'électrode de cathode connus.

Dans le cas d'une structure à diodes concentriques du type décrit en relation avec les figures 3A, 3B, 4, 5A, 5B, 6, 7A, 7B, un tel agencement d'électrode peut être prévu dans la diode centrale D₁ du dispositif.

En particulier, l'agencement décrit en relation avec les figures 8A, 8B ou 9 peut être utilisé tel quel pour la diode D₁ du dispositif des figures 5A et 5B (montage série).

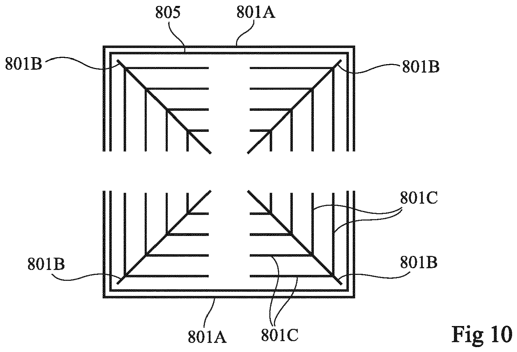

La figure 10 illustre un exemple d'agencement des électrodes de la diode D₁ pouvant être utilisé dans le dispositif des figures 7A et 7B (montage série/antiparallèle). La principale différence par rapport aux exemples des figures 8A, 8B et 9 est que l'anneau polygonal 801A de l'électrode de cathode 801 est séparé en deux parties disjointes s'étendant chacune sur sensiblement la moitié de la longueur de la périphérie extérieure de la diode. De plus, l'électrode de cathode 805 est réduite à un demi-anneau s'étendant sur sensiblement la moitié de la longueur de la périphérie extérieure de la diode.

Dans l'exemple représenté, le demi-anneau 805 est continu et les barreaux 801B situés sur le trajet du demi-anneau 805 sont interrompus pour ne pas passer sous l'électrode 805 (de façon similaire à ce qui a été décrit en relation avec la figure 9). A titre de variante, le demi-anneau 805 peut être interrompu au niveau de chacun de ses sommets de façon à ne pas passer au-dessus des barreaux 801B de l'électrode 801 (de façon similaire à ce qui a été décrit en relation avec les figures 8A et 8B).

Dans le cas d'une structure à diodes concentriques du type décrit en relation avec les figures 3A, 3B, 4, 5A, 5B, 6, 7A, 7B, un agencement d'électrodes similaire à ce qui a été décrit en relation avec les figures 8A, 8B, 9 et 10 peut être prévu dans chacune des diodes annulaires de rang supérieur à 1 du dispositif.

### Procédé de fabrication (exemple)

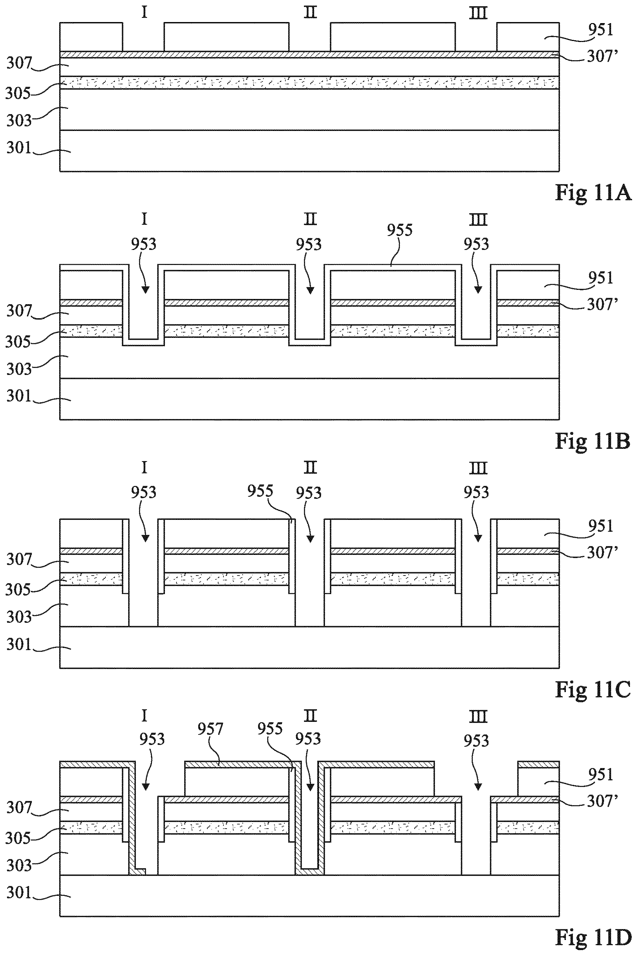

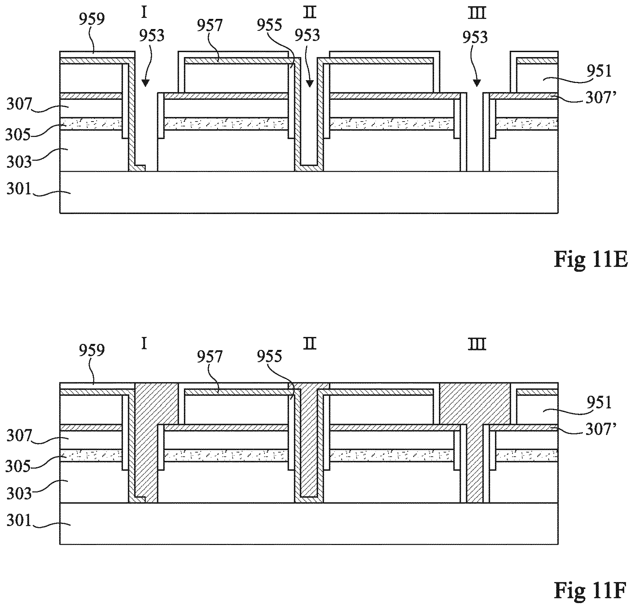

Les figures 11A, 11B, 11C, 11D, 11E, 11F sont des vues en coupe illustrant de façon schématique et partielle un exemple d'un mode de réalisation d'un procédé de fabrication de dispositifs du type décrit ci-dessus. Les figures 11A, 11B, 11C, 11D, 11E, 11F détaillent plus particulièrement la réalisation de trois types de métallisation de contact caractéristiques pouvant être présentes dans les dispositifs décrits ci-dessus, à savoir :
I) une métallisation reliant la région de cathode 303 d'une diode à la région d'anode 307 d'une diode voisine, correspondant par exemple aux métallisations 521ᵢ des figures 5A et 5B ou aux métallisations 721ᵢ ou 723ᵢ des figures 7A et 7B ;
II) une métallisation d'amenée de courant dans la région de cathode d'une diode, correspondant par exemple aux barreaux 801B ou 801C des figures 8A, 8B, 9 ou 10 ; et
III) une métallisation reliant les régions d'anode de deux diodes voisines, correspondant par exemple aux métallisations 733ᵢ des figures 7A et 7B.

La figure 11A illustre un empilement de départ comportant le substrat de support 301, et, dans l'ordre à partir de la face supérieure du substrat 301, une couche 303 de nitrure de gallium dopé de type N, une couche émissive 305, et une couche 307 de nitrure de gallium dopé de type P. Dans l'exemple de la figure 11A, l'empilement de départ comporte en outre, sur et en contact avec la face supérieure de la couche 307 de nitrure de gallium dopé de type P, une couche métallique 307'. La couche métallique 307' forme un contact ohmique avec la face supérieure de la couche d'anode 307. La couche 307' est par exemple une couche unique, ou un empilement de plusieurs couches métalliques distinctes. La face de la couche 307' tournée vers la couche 307 est par exemple réfléchissante, ce qui permet, dans le cas d'un dispositif destiné à émettre de la lumière du côté de la face inférieure du substrat 301, de renvoyer vers le substrat 301 la lumière émise par la diode en direction de sa face opposée au substrat 301, et ainsi d'augmenter le rendement lumineux du dispositif. A titre d'exemple, la couche 307' est une couche d'argent, d'aluminium, ou d'un alliage argent-aluminium. La couche 307', bien que non représentée sur les figures précédentes, peut être prévue dans tous les modes de réalisation décrits en relation avec les figures 3A, 3B, 4, 5A, 5B, 6, 7A, 7B, 8A, 8B, 9, 10, revêtant sensiblement toute la surface supérieure de la région d'anode 307 des diodes.

La figure 11A illustre une étape de dépôt, sur la face supérieure de l'empilement de départ, c'est-à-dire sur la face supérieure de la couche 307' dans cet exemple, d'une couche de masquage 951, par exemple en oxyde de silicium.

La figure 11A illustre en outre une étape de réalisation d'ouvertures traversantes dans la couche de masquage 951, par exemple par lithographie et gravure, en regard des zones dans lesquelles on souhaite former les métallisations de type I), II) et III).

La figure 11B illustre une étape ultérieure de gravure de tranchées 953 traversant la couche métallique 307', les couches 307 et 305, et une partie de l'épaisseur de la couche 303, en regard des ouvertures préalablement formées dans la couche 951, en utilisant la couche 951 comme masque de gravure.

La figure 11B illustre en outre une étape ultérieure de dépôt conforme d'une couche isolante 955 par exemple en oxyde de silicium, sur toute la surface supérieure de la structure, et en particulier sur les parois latérales et sur le fond des tranchées 953.

La figure 11C illustre une étape ultérieure de gravure anisotrope de la couche isolante 955, au cours de laquelle sont retirées les portions de la couche 955 revêtant le fond des tranchées 953, de façon à libérer l'accès à la face supérieure de la couche 303 au fond des tranchées 953, sans retirer les portions de la couche 955 revêtant les parois latérales des tranchées 953.

La figure 11C illustre en outre une étape ultérieure de gravure de la partie inférieure de la couche 303 en regard des ouvertures du masque 951, de façon à prolonger les tranchées 953 jusqu'à la face supérieure du substrat 301.

La figure 11D illustre une étape ultérieure de dépôt conforme d'une couche métallique 957 destinée à former un contact ohmique avec les flancs de la couche de nitrure de gallium de type N 303. La couche 957 est d'abord déposée sur sensiblement toute la surface supérieure de la structure, et notamment sur les parois latérales et sur le fond des tranchées 953.

Au niveau des métallisations de type I (connexion cathode-anode), la couche métallique 957 est ensuite localement retirée sur le flanc de l'une des deux diodes séparées par la tranchée 953 (celle dont l'anode doit être connectée à la cathode de l'autre diode).

De plus, au niveau des métallisations de type III (connexion anode-anode), la couche métallique 957 est localement retirée sur les flancs des deux diodes séparées par la tranchée 953.

Le retrait local de la couche 957 est par exemple réalisé par lithographie et gravure (étapes non détaillées).

La figure 11D illustre en outre une étape de gravure localisée de la couche de masquage 951, de façon à prolonger les ouvertures du masque 951 en regard des régions de connexion d'anode des métallisations de type I et III, de façon à libérer l'accès à la face supérieure de la couche métallique 307' dans ces régions.

La figure 11E illustre une étape ultérieure de dépôt conforme d'une couche isolante 959 sur sensiblement toute la surface supérieure de la structure. La couche 959 est ensuite retirée localement sur les portions de la couche métallique 957 situées dans les tranchées 953, au niveau des métallisations de type I et II. La couche isolante 959 est en outre retirée localement au-dessus des régions de connexion d'anode des métallisations de type I et III.

La figure 11F illustre une étape ultérieure de remplissage des tranchées 953 par un métal conducteur, par exemple du cuivre, de façon à former les métallisations de type I, II et III recherchées.

Des modes de réalisation particuliers ont été décrits. Diverses variantes et modifications apparaîtront à l'homme de l'art. En particulier, bien que l'on ait décrit uniquement des exemples de réalisation se rapportant à des diodes électroluminescentes au nitrure de gallium, les modes de réalisation décrits ne se limitent pas à ce cas particulier. A titre de variante, les modes de réalisation décrits peuvent être adaptés à des diodes électroluminescentes utilisant d'autres matériaux semiconducteurs que le nitrure de gallium, par exemple des diodes au silicium, ou encore à des diodes photoréceptrices, ou encore à des diodes sans fonction optique, par exemple des diodes de puissance. On notera en particulier que dans le cas de diodes photoréceptrices, les motifs d'électrode de cathode décrits en relation avec les figures 8A, 8B, 9 et 10 permettent d'améliorer la collecte des charges photogénérées.

En outre, bien que l'on ait décrit uniquement des exemples de réalisation dans lesquels le contact sur les régions de cathode des diodes est pris sur les parois latérales de tranchées traversant entièrement l'empilement actif des diodes, les modes de réalisation décrits ne se limitent pas à ce cas particulier. En particulier, les premier et deuxième aspects décrits ci-dessus peuvent être adaptés à des diodes du type décrit en relation avec la figure 1, dans lesquelles le contact sur les régions de cathode des diodes est pris sur la face supérieure de régions dans lesquelles la couche d'anode a été localement retirée. De plus, le premier aspect décrit ci-dessus peut être adapté à des diodes dites à injection verticale (par opposition aux diodes à injection latérale du type décrit dans la présente description), dans lesquelles le contact sur les régions de cathode des diodes est pris depuis la face inférieure de la région de cathode.

De plus, dans les modes de réalisation décrits, les types de conductivité P (anode) et N (cathode) des régions semiconductrices 307 et 303 peuvent être inversés.

## Revendications

1. Diode comprenant un empilement vertical de première (303) et deuxième (307) régions semiconductrices de types de conductivité opposés, et une première électrode (801) de polarisation de sa première région (303) disposée dans une tranchée s'étendant depuis la face de la deuxième région (307) opposée à la première région (303), la première électrode (801) comprenant, en vue de dessus, les éléments conducteurs suivants :
un anneau polygonal (801A) ;
pour chaque sommet de l'anneau polygonal (801A), un premier barreau rectiligne (801B) s'étendant entre le sommet et le centre de l'anneau, selon une direction allant du sommet au centre de l'anneau ; et
pour chaque premier barreau (801B), une pluralité de deuxièmes barreaux rectilignes (801C) s'étendant depuis le premier barreau (801B) parallèlement aux côtés de l'anneau (801A) partant du sommet duquel est issu le premier barreau (801B) **caractérisé par** les dimensions des premiers (801B) et deuxièmes (801C) barreaux, qui sont telles que le volume de la deuxième région (307) situé, vu de dessus, à l'intérieur de l'anneau (801A), est continu.

2. Diode selon la revendication 1, dans laquelle, pour chaque premier barreau (801B), la première électrode (801) comprend une ou plusieurs paires de deuxièmes barreaux (801C) issus du premier barreau (801B), et dans laquelle, dans chaque paire de deuxièmes barreaux (801C), les barreaux de la paire partent d'un même point du premier barreau (801B).

3. Diode selon la revendication 2, dans laquelle, dans chaque paire de deuxièmes barreaux (801C) :
un premier barreau de la paire s'étend parallèlement à un premier côté de l'anneau (801A) relié au sommet duquel est issu le premier barreau (801B) duquel sont issus les deuxièmes barreaux (801C) de la paire, en direction opposée à un deuxième côté de l'anneau (801A) relié audit sommet ; et
un deuxième barreau de la paire s'étend parallèlement au deuxième côté de l'anneau (801A) relié au sommet duquel est issu le premier barreau (801B) duquel sont issus les barreaux (801C) de la paire, en direction opposée au premier côté de l'anneau (801A) relié audit sommet.

4. Diode selon la revendication 2 ou 3, dans laquelle, pour chaque premier barreau (801B), les paires de deuxièmes barreaux (801C) reliées au premier barreau (801B) sont régulièrement réparties le long du premier barreau (801B).

5. Diode selon l'une quelconque des revendications 1 à 4, dans laquelle chaque deuxième barreau (801C) s'interrompt avant d'atteindre une droite reliant le centre de l'anneau (801A) au milieu du côté de l'anneau (801A) parallèle audit deuxième barreau (801C) et relié au sommet duquel est issu le premier barreau (801B) duquel est issu le deuxième barreau (801C).

6. Diode selon l'une quelconque des revendications 1 à 5, comportant en outre une deuxième électrode (805) de polarisation de sa deuxième région (307) disposée sur la face de la deuxième région (307) opposée à la première région (303).

7. Diode selon la revendication 6, dans laquelle la deuxième électrode (805) a, vue de dessus, la forme d'un anneau inclus dans l'anneau polygonal (801A) de la première électrode (801) .

8. Diode selon la revendication 7, dans laquelle l'anneau de la deuxième électrode (805) est interrompu au niveau de chacune des intersections avec les premiers barreaux (801B) de la première électrode de façon à ne pas passer au-dessus desdits premiers barreaux (801B).

9. Diode selon la revendication 7, dans laquelle l'anneau de la deuxième électrode (805) est continu, et dans laquelle les premiers barreaux (801B) de la première électrode (801) sont interrompus aux intersections avec l'anneau de la deuxième électrode (805) de façon à ne pas passer sous ledit anneau (805).

10. Diode selon l'une quelconque des revendications 1 à 9, dans laquelle l'anneau polygonal (801A) de la première électrode (801) est séparé en deux parties disjointes s'étendant chacune sur sensiblement la moitié de la longueur de la périphérie de la diode.

## Patentansprüche

1. Diode mit einem vertikalen Stapel von ersten (303) und zweiten (307) Halbleiterbereichen mit entgegengesetzten Leitfähigkeitstypen und einer ersten Elektrode (801) zum Vorspannen ihres ersten Bereichs (303), die in einem Graben angeordnet ist, der sich von der Oberfläche des zweiten Bereichs (307) gegenüber dem ersten Bereich (303) erstreckt, wobei die erste Elektrode (801) von oben gesehen die folgenden leitenden Elemente aufweist:
einen polygonalen Ring (801A);
für jeden Scheitelpunkt des polygonalen Rings (801A) einen ersten geradlinigen Stab (801B), der sich zwischen dem Scheitelpunkt und der Mitte des Rings entlang einer Richtung erstreckt, die vom Scheitelpunkt zur Mitte des Rings verläuft; und
für jeden ersten Stab (801B) eine Vielzahl von zweiten geradlinigen Stäben (801C), die sich von dem ersten Stab (801B) parallel zu den Seiten des Rings (801A) erstrecken, ausgehend von dem Scheitelpunkt, der den Ursprung des ersten Stabes (801B) bildet,
**gekennzeichnet durch** die Abmessungen der ersten (801B) und zweiten (801C) Stäbe, die so sind, dass das Volumen des zweiten Bereichs (307), der sich in der Draufsicht innerhalb des Rings (801A) befindet, kontinuierlich ist.

2. Diode nach Anspruch 1, wobei für jeden ersten Stab (801B) die erste Elektrode (801) ein oder mehrere Paare von zweiten Stäben (801C) aufweist, die sich von dem ersten Stab (801B) erstrecken, und wobei in jedem Paar von zweiten Stäben (801C) die Stäbe des Paares von einem gleichen Punkt des ersten Stabes (801B) ausgehen.

3. Diode nach Anspruch 2, wobei in jedem Paar von zweiten Stäben (801C):
ein erster Stab des Paares sich parallel zu einer ersten Seite des Rings (801A) erstreckt, verbunden mit dem Scheitelpunkt, der den Ursprung des ersten Stabes (801B) bildet, von dem sich die zweiten Stäbe (801C) des Paares erstrecken, und zwar in einer Richtung entgegengesetzt zu einer zweiten Seite des Rings (801A), verbunden mit dem Scheitelpunkt; und
ein zweiter Stab des Paares sich parallel zu der zweiten Seite des Rings (801A) erstreckt, verbunden mit dem Scheitelpunkt, der den Ursprung des ersten Stabes (801B) bildet, von dem sich die Stäbe (801C) des Paares erstrecken, und zwar in einer Richtung entgegengesetzt zur ersten Seite des Rings (801A), verbunden mit dem Scheitelpunkt.

4. Diode nach Anspruch 2 oder 3, wobei für jeden ersten Stab (801B) die mit dem ersten Stab (801B) verbundenen Paare von zweiten Stäben (801C) regelmäßig entlang des ersten Stabs (801B) verteilt sind.

5. Diode nach einem der Ansprüche 1 bis 4, wobei jeder zweite Stab (801C) unterbrochen wird, bevor er eine gerade Linie erreicht, die die Mitte des Rings (801A) mit der Mitte der Seite des Rings (801A) parallel zu dem zweiten Stab (801C) verbindet und mit dem Scheitelpunkt verbunden ist, der den Ursprung des ersten Stabes (801B) bildet, von dem sich der zweite Stab (801C) erstreckt.

6. Diode nach einem der Ansprüche 1 bis 5, die ferner eine zweite Elektrode (805) zum Vorspannen ihres zweiten Bereichs (307) aufweist, die auf der Oberfläche des zweiten Bereichs (307) gegenüber dem ersten Bereich (303) angeordnet ist.

7. Diode nach Anspruch 6, wobei die zweite Elektrode (805) in der Draufsicht die Form eines Rings aufweist, der in dem polygonalen Ring (801A) der ersten Elektrode (801) enthalten ist.

8. Diode nach Anspruch 7, wobei der Ring der zweiten Elektrode (805) auf der Ebene jedes der Schnittpunkte mit den ersten Stäben (801B) der ersten Elektrode unterbrochen ist, um nicht über die ersten Stäbe (801B) hinweg zu erstrecken.

9. Diode nach Anspruch 7, wobei der Ring der zweiten Elektrode (805) kontinuierlich ist, und wobei die ersten Stäbe (801B) der ersten Elektrode (801) an den Schnittpunkten mit dem Ring der zweiten Elektrode (805) unterbrochen sind, um sich nicht unter den Ring (805) zu erstrecken.

10. Diode nach einem der Ansprüche 1 bis 9, wobei der polygonale Ring (801A) der ersten Elektrode (801) in zwei getrennte Abschnitte unterteilt ist, die sich jeweils entlang im Wesentlichen der halben Länge des Diodenumfangs erstrecken.

## Claims

1. A diode comprising a vertical stack of first (303) and second (307) semiconductor regions having opposite conductivity types, and a first electrode (801) for biasing its first region (303) arranged in a trench extending from the surface of the second region (307) opposite to the first region (303), the first electrode (801) comprising, in top view, the following conductive elements:
a polygonal ring (801A);
for each vertex of the polygonal ring (801A), a first rectilinear bar (801B) extending between the vertex and the center of the ring, along a direction running from the vertex to the center of the ring; and
for each first bar (801B), a plurality of second rectilinear bars (801C) extending from the first bar (801B) parallel to the sides of the ring (801A), starting from the vertex forming the origin of the first bar (801B),
**characterized by** the dimensions of the first (801B) and second (801C) bars, that are such that the volume of the second region (307) located, in top view, within the ring (801A), is continuous.

2. The diode of claim 1, wherein, for each first bar (801B), the first electrode (801) comprises one or a plurality of pairs of second bars (801C) extending from the first bar (801B) and wherein, in each pair of second bars (801C), the bars of the pair start from a same point of the first bar (801B).

3. The diode of claim 2, wherein, in each pair of second bars (801C):
a first bar of the pair extends parallel to a first side of the ring (801A) connected to the vertex forming the origin of the first bar (801B) having the second bars (801C) of the pair extending therefrom, in a direction opposite to a second side of the ring (801A) connected to said vertex; and
a second bar of the pair extends parallel to the second side of the ring (801A) connected to the vertex forming the origin of the first bar (801B) having the bars (801C) of the pair extending therefrom, in a direction opposite to the first side of the ring (801A) connected to said vertex.

4. The diode of claim 2 or 3, wherein, for each first bar (801B), the pairs of second bars (801C) connected to the first bar (801B) are regularly distributed along the first bar (801B).

5. The diode of any of claims 1 to 4, wherein each second bar (801C) is interrupted before it reaches a straight line connecting the center of the ring (801A) to the middle of the side of the ring (801A) parallel to said second bar (801C) and connected to the vertex forming the origin of the first bar (801B) having the second bar (801C) extending therefrom.

6. The diode of any of claims 1 to 5, further comprising a second electrode (805) for biasing its second region (307) arranged on the surface of the second region (307) opposite to the first region (303).

7. The diode of claim 6, wherein the second electrode (805) has, in top view, the shape of a ring contained within the polygonal ring (801A) of the first electrode (801).

8. The diode of claim 7, wherein the ring of the second electrode (805) is interrupted at the level of each of the intersections with the first bars (801B) of the first electrode so as not to pass above said first bars (801B).

9. The diode of claim 7, wherein the ring of the second electrode (805) is continuous, and wherein the first bars (801B) of the first electrode (801) are interrupted at the intersections with the ring of the second electrode (805) so as not to pass under said ring (805).

10. The diode of any of claims 1 to 9, wherein the polygonal ring (801A) of the first electrode (801) is separated in two separate portions, each extending along substantially half the length of the diode periphery.
